# EUROPÄISCHE PATENTSCHRIFT

(11) **EP 0 262 356 B1**
(45) Veröffentlichungstag und Bekanntmachung des Hinweises auf die Patenterteilung: **31.03.1993**
(21) Anmeldenummer: 87111702.4
(22) Anmeldetag: 12.08.1987
(51) Int. Cl.: H01L 21/225, H01L 21/306, H01L 29/06

(54) **Verfahren zur Herstellung eines pn-Übergangs hoher Spannungsfestigkeit**
Process for manufacturing a high-voltage resistant PN junction
Méthode de fabrication d'une jonction P-N à haute tenue en tension

(30) Priorität: 30.09.1986 DE 3633188
(43) Veröffentlichungstag der Anmeldung: 06.04.1988
(73) Patentinhaber: SIEMENS AKTIENGESELLSCHAFT, 80333 München (DE)
(72) Erfinder: Kuhnert, Reinhold, Dr. Dipl.-Phys., D-8000 München 2 (DE); Schulze, Hans-Joachim, Dr. Dipl.-Phys., D-8011 Anzing (DE)

(56) Entgegenhaltungen:
- EP-A- 0 176 778
- GB-A- 2 131 603
- US-A- 4 450 469
- US-D- 480 292
- INTERNATIONAL ELECTRON DEVICES MEETING, Washington, D.C., 1.-4. Dezember 1985, Seiten 154-157, IEEE, New York, US; R. STENGL et al.: "Variation of lateral doping - A new concept to avoid high voltage breakdown of planar junctions"

## Beschreibung

Die Erfindung bezieht sich auf ein Verfahren zur Herstellung eines pn-Übergangs hoher Spannungsfestigkeit, der im wesentlichen parallel zur Grenzfläche eines dotierten Halbleiterkörpers verläuft und sich in seinem Randbereich der Grenzfläche annähert, nach dem Oberbegriff des Patentanspruchs 1.

Bekannte Verfahren dieser Art weisen einen Schritt auf, in dem zugleich mit dem pn-Übergang ein oder mehrere diesen umgebende feldbegrenzende Ringstrukturen in den Halbleiterkörper eindiffundiert werden. Diese Ringstrukturen, deren Eindringtiefe der des pn-Übergangs entspricht, sind im Betrieb von äußeren Potentialen freigeschaltet und wirken als Spannungsteiler, wobei die Teilungsverhältnisse durch ihre gegenseitigen Abstände und den Abstand der innersten Ringstruktur vom pn-Übergang bestimmt sind. Hierzu sei auf das Buch von A. Blicher "Thyristor Physics", Springer-Verlag 1976, S. 231-234 verwiesen. Der Nachteil solcher Ringstrukturen liegt darin, daß sie zur Erzielung hoher Durchbruchspannungen eine relativ große Halbleiterfläche benötigen und sehr empfindlich gegen Oberflächenladungen sind.

Der Erfindung liegt die Aufgabe zugrunde, ein Verfahren der eingangs genannten Art anzugeben, das eine einfache Herstellung eines flächensparenden pn-Übergangs hoher Spannungsfestigkeit gewährleistet. Das wird erfindungsgemäß durch eine Ausbildung desselben nach dem kennzeichnenden Teil des Patentanspruchs 1 erreicht.

Das erfindungsgemäße Verfahren ermöglicht die Herstellung eines pn-Übergangs mit einfachen Verfahrensschritten, wobei die streifenförmigen Ausnehmungen entlang der bzw. im Abstand zur lateralen Begrenzung des pn-Übergangs bei relativ geringem Aufwand an Halbleiterfläche eine weitgehend gleichmäßige Verteilung der Dotierstoffkonzentration in Längsrichtung der Streifen gewährleisten. Hierdurch wird eine hohe Durchbruchspannung des pn-Übergangs erreicht.

Die Patentansprüche 2 bis 6 sind auf bevorzugte Ausgestaltungen des erfindungsgemäßen Verfahrens gerichtet.

Die Erfindung wird nachfolgend anhand der Zeichnung näher erläutert. Dabei veranschaulichen die
- Figuren 1 bis 3: einzelne Verfahrensschritte bei der Herstellung eines pn-Übergangs nach einer ersten Ausgestaltung des erfindungsgemäßen Verfahrens, die
- Figuren 4 und 5: einzelne Verfahrensschritte bei einer zweiten Ausgestaltung des erfindungsgemäßen Verfahrens und die
- Figuren 6 und 7: einzelne Verfahrensschritte bei einer dritten Ausgestaltung des Verfahrens nach der Erfindung.

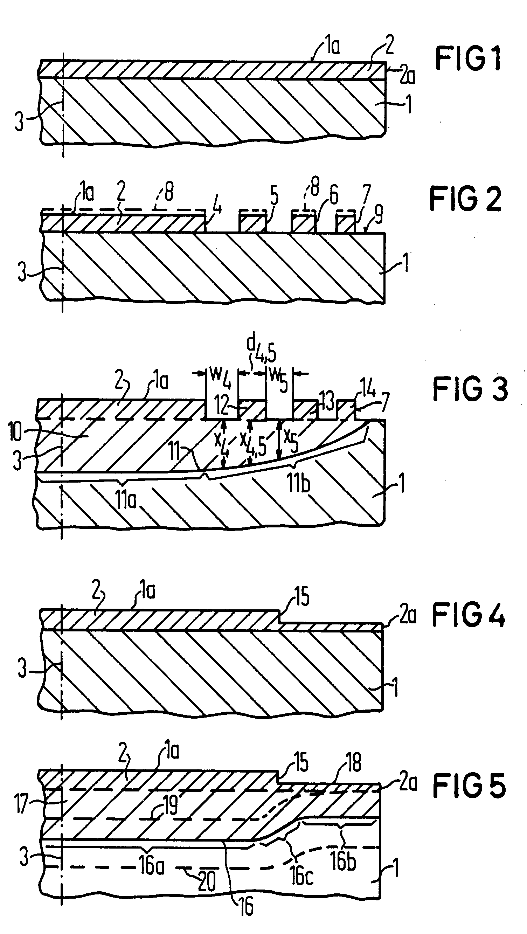

In Fig. 1 ist ein Halbleiterkörper 1, z.B. aus n-dotiertem Silizium mit einer Dotierungskonzentration von 10¹⁴cm⁻³ dargestellt, in den ein p-leitendes Halbleitergebiet eingefügt werden soll. Hierzu wird ein eine p-Leitung bewirkender Dotierstoff, z.B. Al, in eine von der oberen Grenzfläche 1a des Halbleiterkörpers ausgehende Zone 2 eingebracht, und zwar mittels eines ersten, auch als "predeposition" bezeichneten Vordiffusionsschrittes. Dabei wird eine entsprechende Diffusionsquelle verwendet, die bei einer vorgegebenen Temperatur, z.B. bei 1060°C, innerhalb eines vorgegebenen Zeitraums, z.B. für eine Dauer von 7 Stunden, den Dotierstoff durch die Grenzfläche 1a in die Zone 2 einbringt. Diesen Vorgang kann man auch als eine Belegung des Halbleiterkörpers 1 im Bereich seiner Grenzfläche 1a mit dem Dotierstoff auffassen. Die hierbei entstandene Zone 2 weist z.B. eine Tiefe von 5 bis 10 µm und eine randseitige Dotierungskonzentration in unmittelbarer Nähe der Grenzfläche 1a von 10¹⁹cm⁻³ auf.

In einem sich anschließenden Verfahrensschritt wird die Zone 2 in der aus Fig. 2 ersichtlichen Weise strukturiert. Der Halbleiterkörper 1 hat, wie in Fig. 2 angedeutet ist, vorzugsweise die Form einer flachen zylindrischen Scheibe mit kreisförmigem Querschnitt, wobei die durch den Mittelpunkt der Querschnittsfläche gehende vertikale Achse mit 3 bezeichnet ist. Bei diesem Schritt werden in der Zone 2 Ausnehmungen 4 bis 7 vorgesehen. Im einzelnen wird zunächst die Grenzfläche 1a mit einer Ätzmaske 8 bedeckt, die durch an sich bekannte fotolithografische Schritte so strukturiert wird, daß sie an den Stellen, an denen die Ausnehmungen 4 bis 7 vorgesehen sind, entfernt wird. In einem sich anschließenden Ätzvorgang werden dann die sich bis zur unteren Grenzfläche 9 der Zone 2 erstreckenden Ausnehmungen 4 bis 7 erzeugt. Die Ausnehmung 7 verläuft dabei entlang des äußeren lateralen Randes des Halbleiterkörpers 1, während die Ausnehmungen 4 bis 6 einen vorgegebenen Abstand zu diesem bzw. zur lateralen Begrenzung 2a (Fig.1) der Zone 2 haben. Die Bodenflächen der Ausnehmungen 4 bis 7 weisen bei der erwähnten kreisförmigen lateralen Begrenzung des Halbleiterkörpers 1 die Form von konzentrischen Kreisringen auf. Dabei seien die Breiten der einzelnen Ausnehmungen mit w bezeichnet und der Abstand zweier nebeneinander liegender Ausnehmungen mit d. Die Größe d/w nimmt dann mit fortschreitendem Abstand r der beiden durch d jeweils voneinander getrennten Ausnehmungen von der Achse 3 ab.

Schließlich folgt ein auch als Nachdiffusion bezeichneter Temperschritt, bei dem der in Fig. 2 dargestellte Halbleiterkörper unter Entfernung der Diffusionsquelle während einer vorgegebenen Zeitspanne von z.B. 20 Stunden einer Temperatur von etwa 1240°C ausgesetzt wird. Dabei diffundieren während der Belegung eingebrachte Dotierstoffatome aus den gemäß Fig. 2 verbliebenen Teilen der Zone 2 weiter in den unterhalb dieser Zone liegenden Teil des Halbleiterkörpers 1 ein, so daß gemäß Fig. 3 ein n-leitendes Gebiet 10 entsteht, das durch einen pn-Übergang 11 von den übrigen Teilen des Halbleiterkörpers 1 getrennt ist. Die aus dem zentralen, keine Ausnehmungen aufweisenden Teil der Zone 2 eindiffundierten Dotierstoffatome bewirken, daß ein erster Abschnitt 11a des pn-Übergangs im wesentlichen parallel zur Grenzfläche 1a verläuft, während die Dotierstoffatome, die aus den zwischen den Ausnehmungen 4 bis 7 stehengebliebenen ringförmigen Teilen 12 bis 14 der Zone 2 eindiffundieren, einen sich allmählich der Bodenfläche 9 der Ausnehmung 7 annähernden Abschnitt 11b des pn-Übergangs ergeben. Diese Annäherung erfolgt so allmählich, daß für den Abschnitt 11b beim Anlegen einer äußeren Spannung, die den pn-Übergang 11 in Sperrichtung vorspannt, eine sehr hohe, mit der für den Bereich 11a geltenden Volumendurchbruchspannung vergleichbare Durchbruchspannung erreicht wird.

Zweckmäßigerweise werden die Parameter w und d der einzelnen Ausnehmungen 4 bis 7 so gewählt, daß sie wesentlich kleiner sind als die doppelten Eindringtiefen der jeweils zugehörigen Teilzonen des Halbleitergebiets 10. Für die Ausnehmungen 4 und 5 gilt danach, daß die Breite w₄ wesentlich kleiner ist als der Wert 2x₄, wenn mit x₄ die in Fig. 3 eingezeichnete Eindringtiefe der unterhalb von 4 liegenden Teilzone von 10 bezeichnet wird, daß die Breite w₅ wesentlich kleiner ist als der Wert 2x₅, wenn x₅ der Eindringtiefe unterhalb der Ausnehmung 5 entspricht, und daß der Abstand d_{4,5} zwischen den Ausnehmungen 4 und 5 wesentlich kleiner ist als der Wert 2x_{4,5}, wenn x_{4,5} die Eindringtiefe unterhalb des Strukturteils 12 kennzeichnet.

Das Prinzip einer zweistufigen Diffusion ist an sich bekannt, z.B. aus dem Buch von R.M. Warner "Integrated Circuits", erschienen 1965 bei der McGraw-Hill Book Company, New York, vgl. insbesondere Seite 294, vierter Absatz. Ein Strukturierungsschritt vor der hier als "drive-in-step" bezeichneten Nachdiffusion läßt sich dieser Veröffentlichung allerdings nicht entnehmen.

Durch den nach der Erfindung vorgenommenen Strukturierungsschritt wird in einfacher Weise erreicht, daß die Dotierungskonzentration in den unterhalb der Ausnehmungen 4 bis 7 liegenden Teilen des Halbleitergebiets 10 mit steigendem Abstand von der Achse 3 allmählich abnimmt, so daß sich die Eindringtiefe des Halbleitergebiets 10 mit wachsendem Abstand von 3 entsprechend verringert.

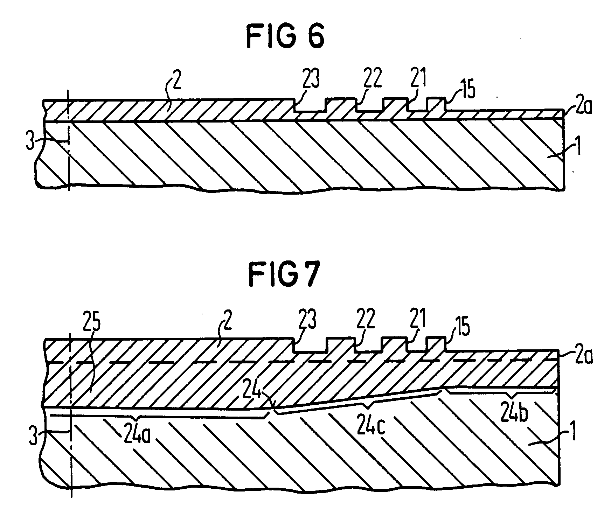

Eine alternative Ausgestaltung des Verfahrens nach der Erfindung sieht vor, nach einer Dotierstoffbelegung des Halbleiterkörpers 1 gemäß Fig. 1 die so entstandene Zone 2 gemäß Fig. 4 in einem Strukturierungsschritt lediglich mit einer einzigen Ausnehmung 15 zu versehen, die entlang der lateralen Begrenzung 2a der Zone 2 verläuft. Dabei ist die Tiefe der Ausnehmung 15 geringer als die Eindringtiefe der Zone 2. Wird der nach Fig. 4 strukturierte Halbleiterkörper 1 dem oben erwähnten Temperschritt unterzogen, so ergibt sich gemäß Fig. 5 ein mit 16 bezeichneter pn-Übergang zwischen dem p-leitenden Halbleitergebiet 17 und dem übrigen Teil des Halbleiterkörpers 1. Der pn-Übergang 16 erstreckt sich hierbei über den ganzen Querschnitt von 1. Ein erster Abschnitt 16a des pn-Übergangs, der sich unterhalb des zentralen Teils der Zone 2 befindet, entspricht dem Abschnitt 11a des pn-Übergangs 11 in Fig. 3. Im Gegensatz zu Fig. 3 verläuft jedoch ein zweiter Abschnitt 16b unterhalb der Ausnehmung 15 parallel zur Grenzfläche 1a, wobei seine Entfernung von der kreisförmigen Bodenfläche 18 der Ausnehmung 15 von der Ätztiefe der Ausnehmung 15 abhängig ist. Mit steigender Ätztiefe verringert sich der Abstand zwischen 16b und 18. Unterhalb der linksseitigen Begrenzung der Ausnehmung 15 ergibt sich ein dritter Abschnitt 16c, der einen Übergang zwischen 16a und 16b darstellt. Führt man dem Halbleiterkörper 1 über Elektroden eine Spannung zu, die den pn-Übergang 16 in Sperrichtung vorspannt, so entsteht eine Raumladungszone mit einer oberen Begrenzung 19 und einer unteren Begrenzung 20.

Wählt man nun die Ätztiefe der Ausnehmung 15 so, daß in deren Bereich nur eine relativ dünne Teilschicht der Zone 2 bestehen bleibt, so fächert sich die Raumladungszone 19, 20 in Richtung auf die laterale Begrenzung 2a der Zone 2 derart auf, daß sie die untere Grenzfläche 18 von 2 erreicht. Damit wird eine hohe oberflächenseitige Durchbruchspannung des pn-Übergangs 16 erreicht.

Eine weitere alternative Ausgestaltung des Verfahrens nach der Erfindung besteht darin, daß die bei einer Dotierstoffbelegung des Halbleiterkörpers 1 gemäß Fig. 1 entstandene Zone 2 nach Fig. 6 in einem Strukturierungsschritt nicht nur mit der Ausnehmung 15, sondern zusätzlich mit weiteren Ausnehmungen 21 bis 23 versehen wird, die jeweils in einem konstanten Abstand zur lateralen Begrenzung 2a der Zone 2 angeordnet sind. Die Ausnehmungen 21 bis 23 nach Fig. 6 unterscheiden sich von den Ausnehmungen 6, 5 und 4 nach Fig. 3 lediglich darin, daß ihre Tiefe kleiner ist als die Eindringtiefe der Zone 2 und insbesondere der Tiefe der Ausnehmung 15 von Fig. 4 entspricht. Unterzieht man den nach Fig. 6 strukturierten Halbleiterkörper 1 dem oben erwähnten Temperschritt, so ergibt sich gemäß Fig. 7 ein mit 24 bezeichneter pn-Übergang, der wieder einzelne Abschnitte 24a bis 24c aufweist und das p-leitende Halbleitergebiet 25 vom übrigen Teil des Halbleiterkörpers trennt. Während die Abschnitte 24a und 24b etwa den Abschnitten 16a und 16b von Fig. 5 ensprechen, verläuft der den Übergang darstellende Abschnitt 24c wesentlich flacher als der Abschnitt 16c, so daß gegenüber der Halbleiterstruktur nach Fig. 5 eine Steigerung der Durchbruchspannung im Übergangsbereich 24c zwischen dem hochdotierten Teil und dem niedriger dotierten Teil des p-leitenden Halbleitergebiets 25 erzielt wird.

Die Verwendung von Al als Dotierstoff bringt gegenüber anderen denkbaren Akzeptoren, wie z.B. Bor oder Gallium, den Vorteil mit sich, daß bei einer vorgegebenen Diffusionszeit und Diffusionstemperatur größere Eindringtiefen erreicht werden. Außerdem ergibt sich z.B. bei Verwendung von Al oder Ga während des Temperschrittes neben dem Eintreiben eines Teils der in der Zone 2 vorhandenen Dotierstoffatome auch eine Ausdiffusion eines anderen Teils der Akzeptoratome, und zwar jeweils durch die Begrenzungsflächen der Zone 2, die gleichzeitig Begrenzungsflächen des Halbleiterkörpers 1 darstellen. Da diese Begrenzungsflächen infolge der Strukturierung der Zone 2 im Bereich der Ausnehmungen, z.B. 4 bis 7, 15 und 21 bis 23, anwachsen, begünstigt die Ausdiffusion eine allmähliche Verringerung der Dotierungskonzentration in dem eindiffundierten Halbleiterbereich 10, 17 oder 25 jeweils im Bereich der Ausnehmungen mit wachsender Entfernung vom Mittelpunkt des Halbleiterkörpers 1.

Andere Ausführungsformen des erfindungsgemäßen Verfahrens betreffen die Herstellung von n-leitenden Halbleitergebieten in p-dotierten Halbleiterkörpern. Hierbei wird ein an sich bekannter, aus Donatoren bestehender Dotierstoff, z.B. Phosphor, verwendet.

Eine vorteilhafte Weiterbildung des Verfahrens nach der Erfindung sieht vor, den verwendeten Dotierstoff, z.B. Aluminium, im Wege einer Vakuumbelegung in die Zone 2 einzubringen. Hierbei wird der Halbleiterkörper 1 neben wenigstens einer Dotierstoffquelle in einen Hohlkörper aus Quarz eingebracht und nach dem Evakuieren desselben während einer vorgegebenen Diffusionszeit einer vorgegebenen Diffusionstemperatur ausgesetzt. Die Diffusionszeit ist dann so zu bemessen, daß eine gewünschte Eindringtiefe der Zone 2 von z.B. 5 bis 10 µm gerade erreicht wird. Ein Vakuum-Diffusionsverfahren, das für die Zwecke einer solchen Vakuumbelegung herangezogen werden kann, ist z.B. dem J. Electrochem. Soc., Vol. 125, No. 6, Juni 1978, S. 957-962, zu entnehmen. Da durch diese Vakuumbelegung erreicht wird, daß die Zone 2 sowohl hinsichtlich der Randkonzentration als auch hinsichtlich der insgesamt eingebrachten Dotierstoffmenge genau einstellbar ist, kann der Ätzvorgang zur Strukturierung der Zone 2 gut auf die erhaltene Eindringtiefe derselben abgestimmt werden.

## Patentansprüche

1. Verfahren zur Herstellung eines pn-Übergangs (11) hoher Spannungsfestigkeit, der im wesentlichen parallel zur Grenzfläche (1a) eines dotierten Halbleiterkörpers (1) eines ersten Leitungstyps verläuft, ein in diesen eingefügtes Halbleitergebiet (10) eines zweiten Leitungstyps von dem übrigen Teil des Halbleiterkörpers (1) trennt und sich in seinem Randbereich der Grenzfläche (1a) annähert, bei dem ein zur Herstellung des Halbleitergebiets (10) dienender Dotierstoff durch diese Grenzfläche (1a) in den Halbleiterkörper (1) eingebracht wird und bei dem ein Teil des eingebrachten Dotierstoffes durch einen Temperschritt tiefer in den Halbleiterkörper eindiffundiert wird, **dadurch gekennzeichnet**, daß der Dotierstoff in eine von der Grenzfläche (1a) des Halbleiterkörpers (1) ausgehende Zone (2) eingebracht wird und daß diese Zone (2) vor dem Temperschritt durch fotolithografische Schritte und einen sich anschließenden maskierten Ätzvorgang mit mehreren streifenförmigen Ausnehmungen (4 bis 7) versehen wird, von denen eine (7) entlang der lateralen Begrenzung (2a) der Zone (2) verläuft und die übrigen Ausnehmungen (4 bis 6) jeweils in einem etwa konstanten Abstand zu dieser lateralen Begrenzung (2a) verlaufen, wobei der Quotient d/w aus dem Abstand d zweier nebeneinander liegender Ausnehmungen (4, 5) und der Breite w der einzelnen Ausnehmungen (4, 5) mit fortschreitendem Abstand der beiden durch d jeweils voneinander getrennten Ausnehmungen (4, 5) vom Mittelpunkt der Querschnittsfläche des Halbleiterkörpers abnimmt und die Dotierungskonzentration in den unterhalb der Ausnehmungen (4 bis 7) liegenden Teilen des Halbleitergebiets (10) mit steigendem Abstand vom Mittelpunkt der Querschnittsfläche allmählich abnimmt, so daß sich die Eindringtiefe des Halbleitergebiets (10) mit wachsendem Abstand vom Mittelpunkt der Querschnittsfläche entsprechend verringert.

2. Verfahren nach Anspruch 1, **dadurch gekennzeichnet**, daß die Bodenflächen (9) der streifenförmigen Ausnehmungen (4 bis 7) der Zone (2) bei einer kreisförmigen lateralen Begrenzung des Halbleitergebiets (10) aus zueinander konzentrischen Kreisringen bestehen.

3. Verfahren nach Anspruch 2, **dadurch gekennzeichnet**, daß der Abstand (d_{4,5}) jeweils zweier benachbarter Kreisringe voneinander und/oder die Breite (w₅) des einen dieser beiden Kreisringe so gewählt sind, daß der Quotient aus dem Abstand (d_{4,5}) und der Breite (w₅) mit wachsender Entfernung der Kreisringe vom Mittelpunkt der Grenzfläche (1a) abnimmt, wobei der Abstand deutlich kleiner gewählt ist als die doppelte, nach dem Temperschritt vorliegende lokale Eindringtiefe des Halbleitergebiets (10) zwischen den beiden Kreisringen und die genannte Breite deutlich kleiner ist als die doppelte, nach dem Temperschritt erreichte lokale Eindringtiefe des Halbleitergebiets (10) unterhalb des diese Breite aufweisenden Kreisrings.

4. Verfahren nach einem der Ansprüche 1 bis 3, **dadurch gekennzeichnet,** daß die Eindringtiefe der Zone (2) die Tiefe der Ausnehmungen (4 bis 7) nicht überschreitet.

5. Verfahren nach einem der Ansprüche 1 bis 3, **dadurch gekennzeichnet**, daß die Tiefe der Ausnehmungen (15, 21 bis 23) geringer ist als die Eindringtiefe der Zone (2).

6. Verfahren zur Herstellung eines pn-Übergangs (16) hoher Spannungsfestigkeit, der im wesentlichen parallel zur Grenzfläche (1a) eines dotierten Halbleiterkörpers (1) eines ersten Leitungstyps verläuft, ein in diesen eingefügtes Halbleitergebiet (17) eines zweiten Leitungstyps von dem übrigen Teil des Halbleiterkörpers (1) trennt und sich in seinem Randbereich der Grenzfläche (1a) annähert, bei dem ein zur Herstellung des Halbleitergebiets (17) dienender Dotierstoff durch diese Grenzfläche (1a) in den Halbleiterkörper (1) eingebracht wird und bei dem ein Teil des eingebrachten Dotierstoffes durch einen Temperschritt tiefer in den Halbleiterkörper eindiffundiert wird, **dadurch gekennzeichnet**, daß der Dotierstoff in eine von der Grenzfläche (1a) des Halbleiterkörpers (1) ausgehende Zone (2) eingebracht wird und daß diese Zone (2) vor dem Temperschritt durch photolithographische Schritte und einen sich anschließenden maskierten Ätzvorgang mit einer streifenförmigen Ausnehmung (15) versehen wird, die entlang der lateralen Begrenzung (2a) der Zone (2) verläuft und deren Tiefe geringer ist als die Eindringtiefe der Zone (2), so daß sich der pn-Übergang (16) über den ganzen Querschnitt des Halbleiterkörpers (1) erstreckt.

7. Verfahren nach einem der vorhergehenden Ansprüche, **dadurch gekennzeichnet**, daß die Einbringung des Dotierstoffes durch die Grenzfläche (1a) in den Halbleiterkörper (1) im Wege einer Vakuumbelegung erfolgt.

## Claims

1. Method of producing a p-n junction (11) which has high dielectric strength and which extends essentially parallel to the boundary surface (1a) of a doped semiconductor body (1) of a first conduction type, isolates a semiconductor domain (10) of a second conduction type embedded in the semiconductor body (1) from the rest of the semiconductor body (1) and approaches the boundary surface (1a) in its peripheral region, in which method a dopant used to produce the semiconductor domain (10) is introduced through said boundary surface (1a) into the semiconductor body (1) and in which process some of the dopant introduced is driven into the semiconductor body more deeply by a heat-treatment step, characterised in that the dopant is introduced into a zone (2) starting from the boundary surface (1a) of the semiconductor body (1), and in that, before the heat-treatment step, said zone (2) is provided, by photolithographic steps and a subsequent masked etching process, with a plurality of strip-type recesses (4 to 7), one (7) of which extends along the lateral boundary (2a) of the zone (2), and the other recesses (4 to 6) each extend at an approximately constant spacing from said lateral boundary (2a), the quotient d/w of the spacing d of two adjacent recesses (4, 5) and the width w of the individual recesses (4, 5) decreasing as the spacing of the two recesses (4, 5), separated from one another in each case by d, from the centre of the cross-sectional area of the semiconductor body decreasing and the doping concentration in the parts of the semiconductor domain (10) which are situated underneath the recesses (4 to 7) gradually decreasing with increasing spacing from the centre of the cross-sectional area, with the result that the penetration depth of the semiconductor domain (10) decreases correspondingly with increasing spacing from the centre point of the cross sectional area.

2. Method according to Claim 1, characterised in that the base areas (9) of the strip-type recesses (4 to 7) of the zone (2) comprise mutually concentric circular rings if the lateral boundary of the semiconductor domain (10) is circular.

3. Method according to Claim 2, characterised in that the spacing (d_{4, 5}) of every two adjacent circular rings from one another and/or the width (w₅) of one of said two circular rings are/is chosen in such a way that the quotient of the spacing (d_{4, 5}) and the width (w₅) decreases with increasing distance of the circular rings from the centre of the boundary surface (1a), the chosen spacing being markedly less than double the local penetration depth, present after the heat-treatment step, of the semiconductor domain (10) between the two circular rings and the width mentioned being markedly less than double the local penetration depth, reached after the heat-treatment step, of the semiconductor domain (10) underneath the circular ring having said width.

4. Method according to one of Claims 1 to 3, characterised in that the penetration depth of the zone (2) does not exceed the depth of the recesses (4 to 7).

5. Method according to one of Claims 1 to 3, characterised in that the depth of the recesses (15, 21 to 23) is less than the penetration depth of the zone (2).

6. Method of producing a p-n junction (16) which has high dielectric strength and which extends essentially parallel to the boundary surface (1a) of a doped semiconductor body (1) of a first conduction type, isolates a semiconductor domain (17) of a second conduction type embedded in the semiconductor body (1) from the rest of the semiconductor body (1) and approaches the boundary surface (1a) in its peripheral region, in which process a dopant used to produce the semiconductor domain (17) is introduced into the semiconductor body (1) through said boundary surface (1a), and in which process some of the dopant introduced is driven into the semiconductor body more deeply by a heat-treatment step, characterised in that the dopant is introduced into a zone (2) starting from the boundary surface (1a) of the semiconductor body (1), and in that, before the heat-treatment step, said zone (2) is provided, by photolithographic steps and a subsequent masked etching process, with a strip-type recess (15) which extends along the lateral boundary (2a) of the zone (2) and whose depth is less than the penetration depth of the zone (2), with the result that the p-n junction (16) extends over the entire cross section of the semiconductor body (1).

7. Method according to one of the preceding claims, characterised in that the dopant is introduced into the semiconductor body (1) through the boundary surface (1a) by means of a vacuum coating.

## Revendications

1. Procédé pour fabriquer une jonction pn (11) à haute rigidité diélectrique, qui s'étend essentiellement parallèlement à la surface limite (1a) d'un corps semiconducteur (1) dopé,d'un premier type de conductivité, qui sépare une zone semiconductrice (10) d'un second type de conductivité insérée dans ce corps semiconducteur, de la partie restante du corps semiconducteur, et qui s'approche par sa zone d'extrémité, de la surface limite (1a), dans lequel un agent de dopage qui sert à fabriquer la zone semiconductrice (10), est introduit à travers cette surface limite (1a) dans le corps semiconducteur (1), et dans lequel une partie de l'agent de dopage introduit est diffusée plus profondément dans le corps semiconducteur (1) par un traitement thermique, caractérisé en ce que l'agent de dopage est introduit dans une zone (2) formée à partir de la surface limite (1a) du corps semiconducteur (1), et en ce que cette zone (2) est pourvue, avant le traitement thermique et par des phases opératoires de photolithographie et un processus d'attaque chimique masqué, de plusieurs creux (4 à 7) en forme de bandes, parmi lesquels un creux (7) s'étend le long de la limite latérale (2a) de la zone (2), alors que les creux restants (4 à 6) s'étendent avec un intervalle à peu près constant de cette limite latérale (2a), du type dans lequel le rapport d/w entre l'intervalle d de deux creux (4, 5) voisins et la largeur w des différents creux (4, 5), diminue avec l'accroissement de l'intervalle des deux creux (4, 5), séparés l'un de l'autre de d, par rapport au centre de la surface de la section transversale du corps semiconducteur alors que la concentration de dopage, dans les parties de la zone semiconductrice (10) disposées sous les creux (4 à 7), diminue progressivement avec l'accroissement de l'intervalle, à partir du centre de la surface de la section transversale, en sorte que la profondeur de pénétration de la zone semiconductrice (10) diminue de manière correspondante avec l'accroissement de l'intervalle, à partir du centre de la surface de la section transversale.

2. Procédé selon la revendication 1, caractérisé en ce que les surfaces de fond (9) des creux (4 à 7) en forme de bandes de la zone (2) sont, dans le cas d'une limitation latérale en forme de cercle de la zone semiconductrice (10), constituées d'anneaux circulaires concentriques les uns par rapport aux autres.

3. Procédé selon la revendication 2, caractérisé en ce que l'intervalle (d_{4,5}) entre deux anneaux circulaires voisins l'un de l'autre et/ou la largeur (w₅) de l'un de ces deux anneaux circulaires sont choisis de telle sorte que le quotient de l'intervalle (d_{4,5}) et de la largeur (w₅) diminue avec l'accroissement de la distance des anneaux circulaires au centre de la surface limite (1a), la distance étant choisie nettement plus petite que la double profondeur de pénétration locale de la zone semiconductrice (10), qui se présente, après la phase du traitement thermique, entre les deux anneaux circulaires, et ladite largeur étant choisie nettement plus petite à la double profondeur de pénétration locale de la zone semiconductrice (10) qui est obtenue, après la phase du traitement thermique, l'anneaux circulaire présentant cette largeur.

4. Procédé selon l'une des revendications 1 à 3, caractérisé en ce que la profondeur de pénétration de la zone (2) ne dépasse pas la profondeur des creux (4 à 7).

5. Procédé selon l'une des revendications 1 à 3, caractérisé en ce que la profondeur des creux (15, 21 à 23) est plus petite que la profondeur de pénétration de la zone (2).

6. Procédé pour fabriquer une jonction pn (16) à haute rigidité diélectrique, qui s'étend essentiellement parallèlement à la surface limite (1a) d'un corps semiconducteur (1) dopé,d'un premier type de conductivité, qui sépare une zone semiconductrice (10) d'un second type de conductivité insérée dans ce corps semiconducteur, de la partie restante du corps semiconducteur, et qui s'approche par sa zone d'extrémité, de la surface limite (1a), dans lequel un agent de dopage qui sert à fabriquer la zone semiconductrice (10), est introduit à travers cette surface limite (1a) dans le corps semiconducteur (1), et dans lequel une partie de l'agent de dopage introduit est diffusée plus profondément dans le corps semiconducteur (1) par un traitement thermique, caractérisé en ce que l'agent de dopage est introduit dans une zone (2) formée à partir de la surface limite (1a) du corps semiconducteur (1), et en ce que cette zone (2), est, avant la phase opératoire de traitement thermique et par des phases opératoires de photolithographie et par un processus d'attaque chimique masqué qui y fait suite, pourvue d'un creux (15) en forme de bande, qui s'étend le long de la limite latérale (2a) de la zone (2) et dont la profondeur est plus petite que la profondeur de pénétration de la zone (2), de sorte que la jonction pn (16) s'étend sur toute la section transversale du corps semiconducteur (1).

7. Procédé selon l'une des revendications précédentes, caractérisé en ce qu'on introduit l'agent de dopage dans le corps semiconducteur (1) à travers la surface limite (1a), au cours de la réalisation d'un vide.
